# EUROPEAN PATENT SPECIFICATION

(11) **EP 4 068 048 B1**
(45) Date of publication and mention of the grant of the patent: **04.06.2025**
(21) Application number: 21306173.2
(22) Date of filing: 30.08.2021
(51) Int. Cl.: G06F 1/20, H05K 7/20

(54) **SYSTEMS AND METHODS FOR AUTONOMOUSLY ACTIVABLE REDUNDANT COOLING OF A HEAT GENERATING COMPONENT**
SYSTEME UND VERFAHREN ZUR AUTONOM AKTIVIERBAREN REDUNDANTEN KÜHLUNG EINER WÄRMEERZEUGUNGSKOMPONENTE
SYSTÈMES ET PROCÉDÉS DE REFROIDISSEMENT REDONDANT ACTIVABLE DE FAÇON AUTONOME D'UN COMPOSANT DE GÉNÉRATION DE CHALEUR

(30) Priority: 01.04.2021 EP 21305427
(43) Date of publication of application: 05.10.2022
(73) Proprietor: OVH, 59100 Roubaix (FR)
(72) Inventor: MENEBOO, Alexandre Alain Jean-Pierre, 62440 Harnes (FR); CHEHADE, Ali, 59283 Moncheaux (FR); BAUCHART, Grégory Francis Louis, 59150 Wattrelos (FR)
(74) Representative: BCF Global

(56) References cited:
- EP-A1- 3 742 097
- GB-A- 2 575 680
- US-A- 2 115 501

## Description

### FIELD

The present technology relates to cooling techniques for electronic equipment. In particular, a cooling system and a method for autonomously activable redundant cooling of a heat generating component are disclosed.

### BACKGROUND

Heat dissipation is an important consideration for computer systems. Notably, many components of a computer system, such as a processor (for example a central processing unit (CPU), a graphical processing unit (GPU), and the like), generate heat and thus require cooling to avoid performance degradation and, in some cases, failure. Similar considerations arise for systems other than computer systems (e.g., power management systems). Different types of cooling systems are therefore implemented to promote heat dissipation from heat-generating components, with the objective being to efficiently collect and conduct thermal energy away from heat-generating components.

Heat sinks rely on a heat transfer medium (e.g., a gas or liquid) to carry away the heat generated by a heat generating component. For example, a water block, which is a water cooling heat sink, is thermally coupled to the component to be cooled (e.g., a processor) and water, or other heat transfer fluid, is made to flow through a conduit in the water block to absorb heat from the heat generating component. As water flows out of the water block, so does the thermal energy collected thereby. As another example, immersion cooling systems have been gaining popularity whereby the heat generating component is immersed in a dielectric coolant or other immersion heat transfer fluid.

Said solutions typically rely on pumping systems to provide a flow of the heat transfer fluid, such that thermal energy may be carried away from the heat generating component. However, such solutions involving liquid and/or fluid for transferring heat are sometimes susceptible to leaks, obstructions in their cooling loop that disable a flow of the heat transfer fluid, or any other failures which can decrease their efficiency and, as such, cause the temperature of the heat generating component to increase.

There is therefore a desire for redundant cooling solutions that may be activated, or "triggered", before overheating of the heat generating component, in order to prevent overheating and any other damages of the heat generating component.

European Patent Application No. 3742097 discloses a water block assembly including first and second water block units having respective first and second fluid conduits. The second water block unit is stacked on the first water block unit. The second fluid conduit operates either in parallel with the first fluid conduit or fluidly independent therefrom, such that cooled fluid is fed to the first and second fluid conduits. The first water block unit includes a first base portion and a first cover portion disposed on and affixed to the first base portion. The first cover portion defines a first fluid inlet and a first fluid outlet of the first fluid conduit. The second water block unit includes a second base portion and a second cover portion disposed on and affixed to the second base portion. The second cover portion defines a second fluid inlet and a second fluid outlet of the second fluid conduit.

### SUMMARY

Embodiments of the present technology have been developed based on developers' appreciation of shortcomings associated with the prior art. The object of the invention is solved by a cooling system according to claim 1. Preferred embodiments are presented in the dependent claims.

In the context of the present specification, unless expressly provided otherwise, electronic equipment may refer, but is not limited to, "servers", "electronic devices", "operation systems", "systems", "computer-based systems", "controller units", "monitoring devices", a "control devices" and/or any combination thereof appropriate to the relevant task at hand.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned objects and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
the backup heat transfer fluid flowing in the at least one fluid path is extracted from the tank by the backup pump.

In some embodiments of the present technology, the backup cooling loop is an open cooling loop fluidly connected to the tank.

In some embodiments of the present technology, the main cooling arrangement comprises a tank filled with a dielectric heat transfer fluid for immersive cooling of the heat generating component, the heat generating component being disposed within the tank such that thermal energy generated therefrom is collected by the dielectric heat transfer fluid; and an immersive cooling pump adapted for causing the dielectric heat transfer fluid to flow within the tank.

In some embodiments of the present technology, the main and backup heat transfer fluid are a same dielectric heat transfer fluid, and the main cooling arrangement comprises a tank filled with the dielectric heat transfer fluid for immersive cooling of the heat generating component, the heat generating component being disposed within the tank such that thermal energy generated therefrom is collected by the dielectric heat transfer fluid; and an immersive cooling pump adapted for causing the dielectric heat transfer fluid to flow within the tank, the at least one fluid path of the backup cooling arrangement being immersed within the tank and being fluidly connected therewith, the backup cooling arrangement further comprising a pump adapted for causing the dielectric heat transfer fluid to flow within the at least one fluid path.

In some embodiments of the present technology, the thermal fuse comprises a phase change material.

In some embodiments of the present technology, the phase change material comprises paraffin wax.

In some embodiments of the present technology, the backup cooling arrangement further comprises a temperature sensor adapted for sensing a temperature of the backup heat transfer fluid in the at least one fluid path, the temperature sensor being communicably connected to a controller.

In some embodiments of the present technology, the temperature sensor is adapted for providing to the controller a signal indicative of a temperature flow of the backup heat transfer fluid in the at least one fluid path for controlling the backup pump.

In some embodiments of the present technology, the temperature threshold is a melting temperature of the phase change material.

In some embodiments of the present technology, the thermal fuse is dissolved in the backup heat transfer fluid in response to its temperature being higher than the temperature threshold

In the context of the present specification, unless expressly provided otherwise, electronic equipment may refer, but is not limited to, "servers", "electronic devices", "operation systems", "systems", "computer-based systems", "controller units", "monitoring devices", a "control devices" and/or any combination thereof appropriate to the relevant task at hand.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned objects and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
Figure 1 is a schematic diagram of a cooling arrangement comprising a liquid cooling block installed on a heat generating component to be cooled;
Figure 2 is a top plan schematic representation of a liquid cooling block of the cooling arrangement of Figure 1;
Figure 3 is a schematic diagram of a cooling system comprising a main cooling arrangement and a backup cooling arrangement in accordance with an embodiment of the present technology;
Figure 4 is a schematic diagram of a cooling system comprising a main cooling arrangement and a backup cooling arrangement in accordance with another embodiment of the present technology;
Figure 5 is a schematic diagram of a cooling system comprising a main cooling arrangement and a backup cooling arrangement in accordance with yet another embodiment of the present technology; and
Figure 6 is a schematic diagram of a cooling system comprising a main cooling arrangement and a backup cooling arrangement in accordance with yet another embodiment of the present technology.

It should also be noted that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various systems that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future.

An aspect of the present technology introduces a cooling system and a method for cooling of a heat generating component, for example a processor, with autonomously activable redundancy. In one embodiment, the cooling system comprises a main cooling arrangement thermally coupled to the heat generating component for cooling thereof. As it will be described in greater details hereinafter, the main cooling arrangement may comprise a liquid cooling block (also called "water block", "cold plate", or "thermal transfer device"), may be an immersive cooling arrangement, or any other cooling arrangement for providing suitable for cooling the heat generating component. The cooling system also comprises a backup cooling arrangement that provide redundancy to the main cooling arrangement. In this embodiment, the backup cooling arrangement is thermally coupled to the main cooling arrangement and comprises a thermal fuse. The thermal fuse is disposed such that it disables the operation of the backup cooling arrangement when a temperature of the thermal fuse is below a temperature threshold, and enables it in response to its temperature being above the temperature threshold.

In other words, the backup cooling arrangement may collect thermal energy of the main cooling arrangement, thereby providing cooling to the heat generating component, in response to the thermal energy generated by the heat generating component exceeding an amount of thermal energy that may be properly collected by the main cooling arrangement. For example, when a failure of the main cooling arrangement arises, thermal energy of the heat generating component is not properly collected and carried away by the main cooling arrangement. The temperature of the cooling system thus increases from a low initial temperature, and a state of the thermal fuse changes from a solid state to a melted state in response to its temperature exceeds a temperature threshold (e.g. a melting temperature of the thermal fuse) , thereby enabling an operation of the backup cooling arrangement to provide cooling to the heat generating component. In this embodiment, once the thermal fuse has melted, the state of the thermal fuse stays in the melted state in response to the temperature of the thermal fuse being below the temperature threshold.

In one embodiment, the backup cooling arrangement comprises a liquid cooling block having an internal fluid path for conducting a backup heat transfer fluid adapted for collecting thermal energy of the main cooling arrangement. The thermal fuse is disposed within the internal fluid path, initially being in a solid state to disable a flow of the backup heat transfer fluid within the liquid cooling block given that the thermal fuse and the internal fluid are at an initial temperature below the temperature threshold upon being disposed within the internal fluid path. When a failure of the first cooling system arises, for example a clogging of a liquid cooling block of the main cooling arrangement, the thermal energy causes the thermal fuse to change from the solid state to a melted state, thereby enabling the flow of the backup heat transfer fluid in the backup cooling arrangement. Thermal energy is thus collected and carried away by the backup cooling arrangement when a failure of the first cooling system arises. As described hereafter, other types of main and backup cooling arrangements are contemplated in alternative embodiments.

With these fundamentals in place, we will now consider some non-limiting examples to illustrate various implementations of aspects of the present technology.

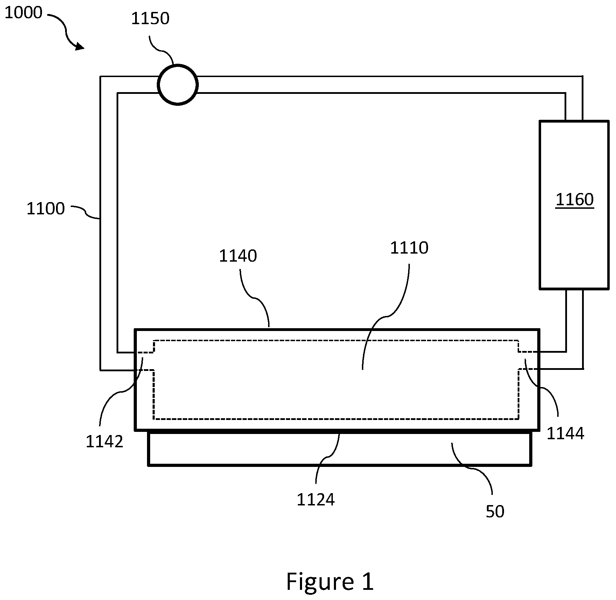

Figure 1 is a schematic diagram of a cooling arrangement 1000 comprising a liquid cooling block 1140 installed on a heat generating component 50 to be cooled. For example, the heat generating component 50 may be a processor of a computer system and may be mounted to a mother board thereof. The computer system may be, for example and without limitation, a server of a datacentre disposed in a rack thereof. Figure 1 is not to scale; while perimeters of the liquid cooling block 1140 and of the heat generating component 50 may be similar, their relative sizes are for illustration purposes only.

In this illustrative example, the cooling arrangement 1000 comprises a cooling loop 1100 comprising the liquid cooling block 1140 thermally coupled to the heat generating component 50. The liquid cooling block 1140 is a heat sink that uses a heat transfer fluid (e.g. water or another liquid) for transferring thermal energy. In some instances, the liquid cooling block 1140 may be a water block and the heat transfer fluid may comprise water. It is to be understood that the term "liquid cooling block" is intended to include such thermal transfer devices that use water, or any fluids other than water and/or multiphase flow (e.g., two-phase flow). For example, in some instance, the fluid may be an oil, an alcohol, or a dielectric heat transfer fluid (e.g., 3M Novec ^{®}).

The liquid cooling block 1140 is configured to receive the heat transfer fluid that is circulated through a fluid path formed by the cooling loop 1100 and an internal conduit 1110 in the liquid cooling block 1140. Circulation of the heat transfer fluid in the internal conduit 1110 allows to absorb the thermal energy from the heat generating component 50. The liquid cooling block 1140 defines a fluid inlet 1142 and a fluid outlet 1144 for respectively feeding and discharging the heat transfer fluid from the internal fluid conduit 1110. As the heat transfer fluid flows out of the liquid cooling block 1140, so does the thermal energy absorbed thereby.

The liquid cooling block 1140 has an external thermal transfer surface 1124 configured to be in thermal contact with the heat-generating component 50. It is to be understood that in this context, the external thermal transfer surface 1124 is said to be "in thermal contact" with the heat-generating component 50 whether the liquid cooling block 1140 is in direct contact with the heat-generating component 50 or when a thermal paste is applied between the external thermal transfer surface 1124 and the heat-generating component 50, in a manner that is known in the art, to ensure adequate heat transfer between the heat-generating component 50 and the external thermal transfer surface 1124.

The cooling loop 110 further comprises a cooling apparatus 1160 (e.g. a heat exchanger) configured for receiving the heated heat transfer fluid from the liquid cooling block 1140. As such, the heated heat transfer fluid discharged from the liquid cooling block 1140 is cooled in the cooling apparatus 1160 before returning to the liquid cooling block 1140. The cooling apparatus 1160 through which the heat transfer fluid is cooled between the fluid outlet 1144 and the fluid inlet 1142 may be of various constructions, being for example an air-to-liquid heat exchanger or a liquid-to-liquid heat exchanger, and will not be described herein.

The cooling loop 1100 also comprises a pump 1150 to pump the heat transfer fluid into and out of the internal conduit 1110 of the liquid cooling block 1140.

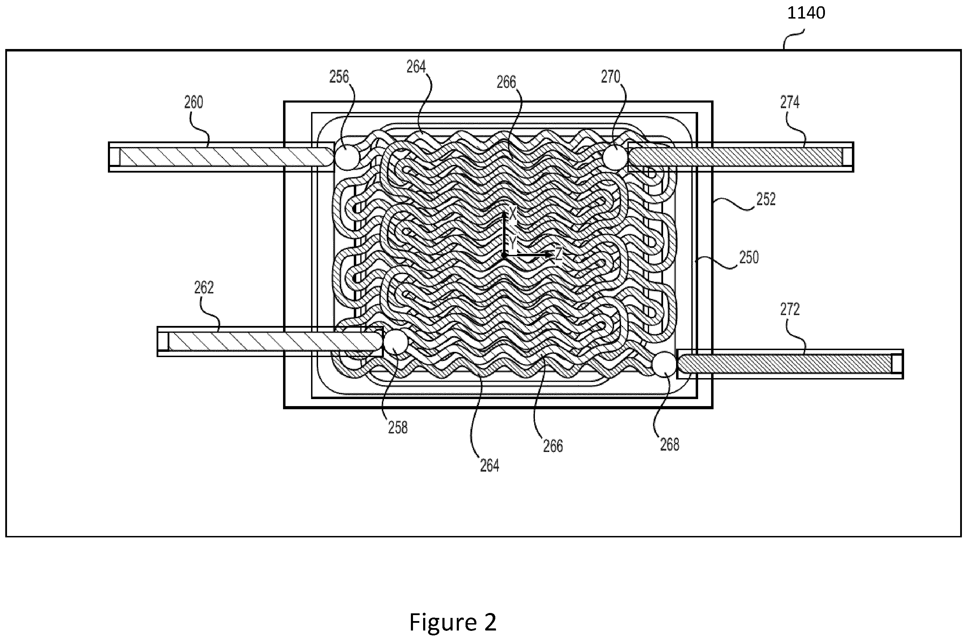

Figure 2 is a top plan schematic representation of the liquid cooling block 1140 mounted on the heat generating component 50. In this illustrative example, the liquid cooling block 1140 may for example comprise two redundant liquid inlets 256 and 258 respectively connectable to redundant conduits 260 and 262 (only their ends are shown) for receiving the heat transfer fluid. The heat transfer fluid may thus flow through redundant liquid channels 264 and 266 that zigzag within the liquid cooling block 1140 to maximize the heat absorption potential of the heat transfer fluid across a surface of the liquid cooling block 1140. The liquid channels 264 and 266 terminate at two redundant liquid outlets 268 and 270 that are respectively connectable to redundant conduits 272 and 274 (only their ends are shown) for hot heat transfer fluid output.

Other shapes of the liquid cooling block 1140 and/or shapes of its conduits are contemplated in alternative embodiments. For example, the liquid cooling block 1140 may comprise a single internal conduit defining a spiral shape.

Broadly speaking, an aspect of the present technology is to introduce a cooling system with autonomously activable redundancy. As such, the cooling system comprises at least a main and a backup cooling arrangements, the backup cooling arrangement being thermally coupled to the main cooling arrangement for redundancy and comprising a thermal fuse. The thermal fuse is disposed such that it disables the operation of the backup cooling arrangement when a temperature of the thermal fuse is below a temperature threshold. More specifically, the thermal fuse opposes the flow of a backup heat transfer fluid within the backup cooling arrangement when a temperature of the backup heat transfer fluid and/or the thermal fuse is lower than the melting temperature of the thermal fuse.

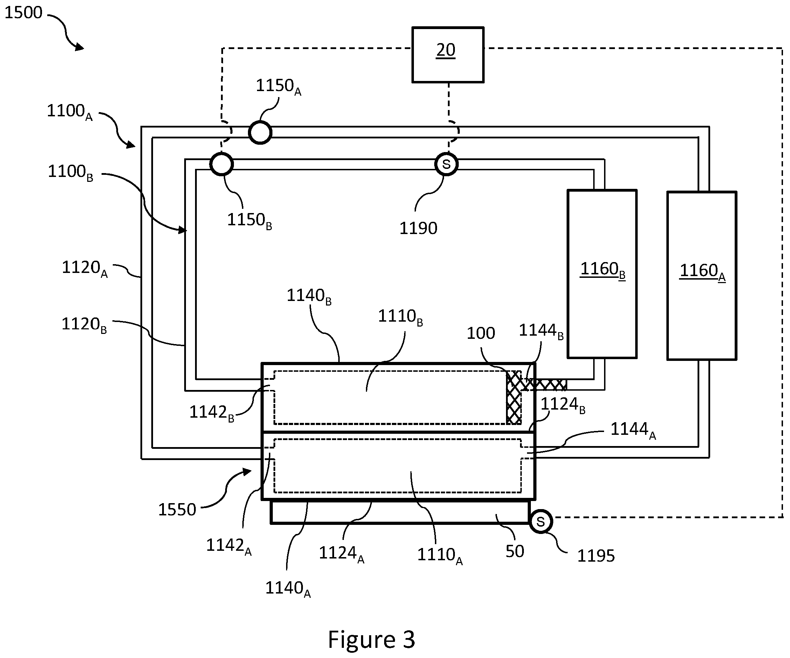

Figure 3 is a schematic diagram of a cooling system 1500 comprising a main cooling arrangement 1100_{A} and a backup cooling arrangement 1100_{B}, each of the main and backup cooling arrangements 1100_{A}, 1100_{B} being similar to the cooling arrangement 1100 described on Figure 1. More specifically, the main cooling arrangement 1100_{A} is formed of a main cooling loop 1120_{A} comprising a main liquid cooling block 1140_{A}, a main pump 1150_{A} and a main cooling apparatus 1160_{A}, a main heat transfer fluid flowing in the main cooling loop 1120_{A}. As previously described with respect to the liquid cooling block 1140, the main liquid cooling block 1140_{A} defines an external thermal transfer surface 1124_{A} configured to be in contact with the heat-generating component 50, such that, in use, thermal energy thereof may be collected by the main heat transfer fluid flowing in an internal fluid conduit 1110_{A} extending between a fluid inlet 1142_{A} and a fluid outlet 1144_{A} of the main liquid cooling block 1140_{A}.

Similarly, the backup cooling arrangement 1100_{B} forms a fluid path comprising a backup cooling loop 1120_{B} including a backup liquid cooling block 1140_{B}, a backup pump 1150_{B} and a backup cooling apparatus 1160_{B}, a backup heat transfer fluid flowing in the backup cooling loop 1120_{B} upon activation of the backup cooling arrangement 1100_{B}. Activation of the backup cooling arrangement 1100_{B} is described in greater details hereafter. As previously described with respect to the liquid cooling block 1140, the backup liquid cooling block 1140_{B} defines an external thermal transfer surface 1124_{B} configured to be in thermal contact with an upper surface of the main liquid cooling block 1140_{A}, the upper surface being opposed to the external thermal transfer surface 1124_{A}. Mounting the backup liquid cooling block 1140_{B} on a surface of the heat-generating component 50 opposite from a mounting surface of the main liquid cooling block 1140_{A} is also contemplated. In use, thermal energy generated by the heat-generating component 50 may be collected by the backup heat transfer fluid flowing in an internal fluid conduit 1110_{B} extending between a fluid inlet 1142_{B} and a fluid outlet 1144_{B} of the backup liquid cooling block 1140_{B}. The main and backup heat transfer fluids may be the same or different types of fluids (e.g. the main heat transfer fluid may be demineralized water and the backup heat transfer fluid may be a refrigerant).

As such, the main and backup liquid cooling blocks 1140_{A}, 1140_{B} define a liquid cooling block assembly 1550. More specifically, the liquid cooling block assembly 1550 comprises the main liquid cooling block 1140_{A}, also referred to as the "lower" liquid cooling block 1140_{A}, and the backup liquid cooling block 1140_{B}, also referred to as the "upper" liquid cooling block 1140_{B} stacked on the lower liquid cooling block 1140_{A} such that, in use, the lower liquid cooling block 1140_{A} is disposed between the upper liquid cooling block 1140_{B} and the heat generating component 50. As will be described in greater detail below, the lower and upper liquid cooling block 1140_{A}, 1140_{B} can, in some cases, provide the liquid cooling block assembly 1550 with redundancy such that if the lower liquid cooling block 1140_{A} were to experience a decrease in performance (e.g., due to a blockage in the fluid path at a level of the main cooling loop 1120_{A} or within the internal fluid conduit 1110_{A}), the upper liquid cooling block 1140_{B} would continue cooling the target component 50.

In this embodiment, the backup cooling arrangement 1100_{B} comprises a thermal fuse 100 initially disposed within at least a portion of the backup cooling loop 1120_{B}. The thermal fuse is configured for changing from a solid state to a melted state in response to its temperature being above a given temperature threshold (i.e. a "melting temperature" of the thermal fuse 100). As such, a flow of the backup heat transfer fluid in the backup cooling loop 1120_{B} is initially blocked due to the presence of the thermal fuse 100 disposed in its solid state.

The thermal fuse 100 is made of a material having a melting temperature higher than a normal operating temperature of the main heat transfer fluid and lower than a maximum safe operating temperature of the heat generating component 50. In normal operation of the cooling system 1500, the temperature of the backup heat transfer fluid is lower than the melting temperature of the thermal fuse 100. The thermal fuse 100 opposes the flow of the backup heat transfer fluid within the cooling loop of the backup cooling arrangement 1100_{B} under such condition.

In this embodiment, the backup cooling arrangement 1100_{B} comprises a controller 20 and a temperature sensor 1195 for sensing a temperature of the heat generating component 50, the temperature sensor 1195 being communicably connected to the controller 20. The backup pump 1150_{B} is communicably connected to the controller 20 such that the controller 20 may, in response to the temperature sensor 1195 sensing that a temperature of the heat generating component 50 is above a heat generating component temperature threshold (e.g. set according to the melting temperature of the thermal fuse 100), actuate the backup pump 1150_{B}.

In response to the temperature of the thermal fuse being above the temperature threshold, the flow of the backup heat transfer fluid is enabled, thereby providing additional cooling to the heat generating component 50 by the backup cooling arrangement 1100_{B}.

More specifically, in the event of a failure of the main cooling arrangement 1100_{A} or abnormal operation thereof (e.g. clogging of the main cooling loop 1120_{A}), the main heat transfer fluid may be unable to suitably collect thermal energy expelled by the heat generating component 50. For example, if a flow rate of the main heat transfer fluid decreases, the main heat transfer fluid may not carry thermal energy in a suitable manner so as to ensure proper cooling of the heat generating component 50. As such, a temperature of the main heat transfer fluid and/or of the main liquid cooling block 1140_{A} may rise. Given that the backup liquid cooling block 1140_{B} is thermally coupled to the main liquid cooling block 1140_{A}, and/or to the heat generating component 50, the temperature of the backup liquid cooling block 1140_{B} may similarly rise until a temperature of the thermal fuse 100 reaches the given temperature threshold, resulting in the melting of the thermal fuse 100 and dispersion of its melted material in the backup heat transfer fluid. As such, the backup cooling arrangement 1100_{B} provides redundant cooling and may be autonomously activated in response to a rise of the temperature of the main heat transfer fluid. In this embodiment, the thermal fuse 100 is dissolved in the backup heat transfer fluid in response to its temperature being higher than the temperature threshold, thus enabling a flow of the backup heat transfer fluid in the backup cooling loop 1120_{B}.

It may be noted that, once melted, the thermal fuse 100 no longer exists and is dispersed and/or dissolved within the backup heat transfer fluid. If the temperature of the backup heat transfer fluid is reduced below the melting temperature of the thermal fuse 100, pieces of the material of the thermal fuse 100 may be expected to solidify and be carried by the backup heat transfer fluid.

As illustrated, the thermal fuse 100 may be disposed proximally to the outlet 1144_{B} of the backup liquid cooling block 1140_{B} and/or within the internal fluid conduit 1110_{B} thereof on Figure 3. Other locations for disposing the thermal fuse 100 are contemplated in alternative embodiments of the present technology such as the inlet 1142_{B} of the backup liquid cooling block 11140_{B}. As an example and without limitation, the thermal fuse 100 may be made a phase change material (PCM), for example paraffin wax, or any other suitable material such as wax, resin, paraffin, grease, silicone, synthetic glue and polymers.

In this embodiment, the backup cooling arrangement 1100_{B} further comprises a flow rate sensor 1190 sensing a flow of the backup heat transfer fluid in the backup cooling loop 1120_{B}. The controller 20 may be communicably connected to the flow rate sensor 190 and may receive data therefrom. In this embodiment, the flow rate sensor 190 may provide a visual information and/or transmit a signal to the controller 20 in response to the flow rate of the backup heat transfer fluid is non-null. As such, an operator of the cooling system 1500 may be provided with the visual information that the flow rate of the backup heat transfer fluid is non-null, the visual information being indicative that a temperature of the main cooling arrangement 1100_{A} has increased and that the temperature of the thermal fuse 100 has reached the temperature threshold.

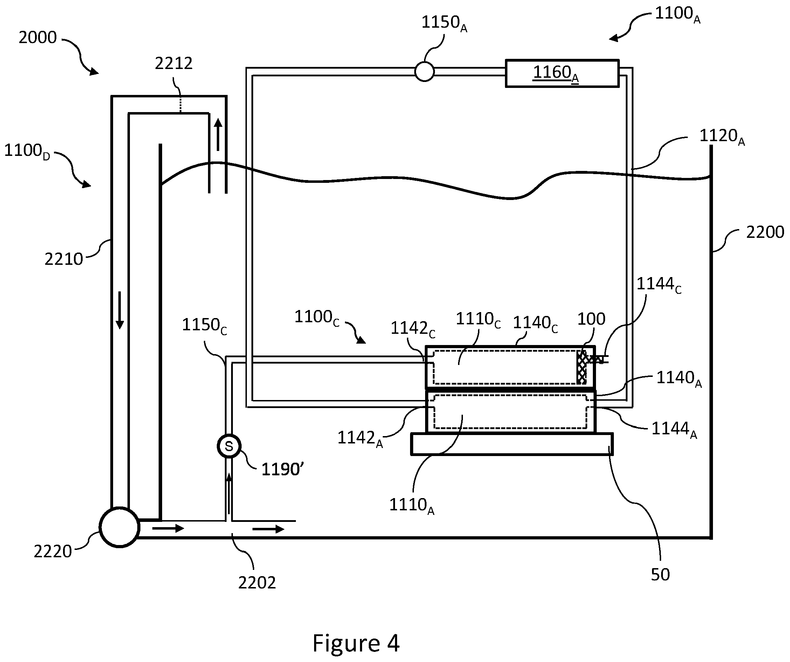

Figures 4 to 6 depict alternative embodiments of the present technology with different types of main and backup cooling arrangements for immersive cooling of the heat generating component 50. Similarly to the backup cooling arrangement 1100_{B} described on Figure 3, backup cooling arrangements described in Figures 4 to 6 hereafter are autonomously activable.

Figure 4 is a schematic diagram of a cooling system 2000 comprising the main cooling arrangement 1100_{A}, a backup cooling arrangement 1100_{C} and an immersion cooling arrangement 1100_{D}.

In this embodiment, the immersion cooling arrangement 1100_{D} comprises a tank 2200 filled with a dielectric heat transfer fluid for collecting thermal energy of the heat generating component 50, the heat generating component 50 being disposed within the tank 2200. As such, the main cooling arrangement 1100_{A}, including the heat generating component 50 and the main liquid cooling block 1140_{A}, is at least partially immersed in the dielectric heat transfer fluid. An immersive cooling pump 2220, or simply "pump 2220", fluidly connected to the tank 2200 is configured for maintaining a flow of the dielectric heat transfer fluid within the tank. The pump 2220 may be external with respect to the tank 2200 or immersed within the tank 2200. A cooling apparatus (not shown) may be provided along the external fluid conduit 2210 to cool the dielectric heat transfer fluid. On the illustrative example of Figure 4, the pump 2220 causes a flow of the dielectric heat transfer fluid from a surface of the tank 2200 to a bottom of the tank 2200 such that tank 2200 receives cooled dielectric heat transfer fluid at a tank inlet 2202.

In this embodiment, the backup cooling arrangement 1100_{C} comprises an open cooling loop comprising a backup liquid cooling block 1140_{C} defining an internal fluid conduit 1110_{C} extending between a fluid inlet 1142_{C} and a fluid outlet 1144_{C} of the backup liquid cooling block 1140_{C}. As depicted on Figure 4, the backup liquid cooling block 1140_{C} defines an external thermal transfer surface configured to be in contact with an upper surface of the main liquid cooling block 1140_{A} such that the backup liquid cooling block 1140_{C} is thermally coupled to the main liquid cooling block 1140_{A}. In this embodiment, the backup cooling arrangement 1100_{C} comprises an immersed fluid conduit 1150_{C} extending between the tank inlet 2202 and the fluid inlet 1142_{C} such that the backup liquid cooling block 1140_{C} is fluidly connected to the tank inlet 2202. As such, the tank inlet 2202 parallelly provides cooled dielectric heat transfer fluid to the backup liquid cooling block 1140_{C} and to the tank 2200.

The thermal fuse 100 is initially disposed within the open cooling loop of the backup cooling arrangement 1100_{C}. As an example, the thermal fuse 100 is disposed in its solid state at or near the fluid outlet 1144_{C} of the backup liquid cooling block 1140_{C} on Figure 4. Other locations for disposing the thermal fuse 100 are contemplated in alternative embodiments of the present technology such as the inlet 1142_{C} of the backup liquid cooling block 1140_{C}. As such, in response to the temperature of the main heat transfer fluid flowing within the main liquid cooling block 1140_{A} being above the melting temperature of the thermal fuse 100, the state of the thermal fuse 100 change from the solid state to the melted state, thereby enabling a flow of the dielectric heat transfer fluid within the internal fluid conduit 1110_{C}, the flow being selectively maintained by the immersed backup pump 1150_{C} that extracts and returns the dielectric heat transfer fluid to and from the tank 2200.

The backup cooling arrangement 1100_{C} may also comprise a flow rate sensor 1190', similar to the flow rate sensor 1190, to sense a flow of the dielectric fluid within the open cooling loop (e.g. within the immersed fluid conduit 1150_{C}). In a non-limiting embodiment, the flow rate sensor 1190' may be communicably connected to a controller (not shown) to provide data thereto, the data comprising indication of a flow of the dielectric fluid within the open cooling loop.

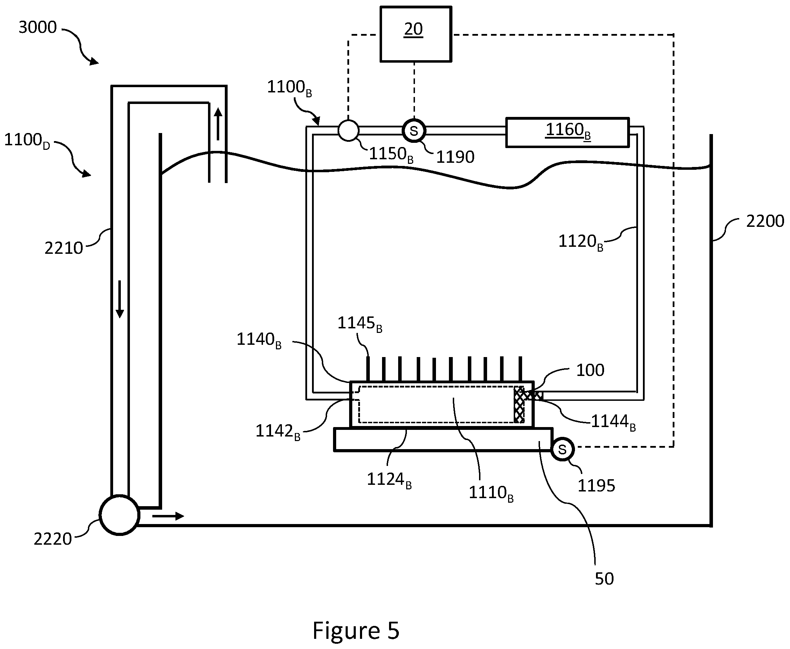

Figure 5 is a schematic diagram of a cooling system 3000 in which the cooling arrangement 1100_{D} is a main cooling arrangement, the cooling system 3000 also comprising the backup cooling arrangement 1100_{B}. In this embodiment, the main cooling arrangement 1100_{D} comprises the tank 2200 filled with the dielectric heat transfer fluid, the pump 2220 and the external fluid conduit 2210. The main cooling arrangement 1100_{D} may also comprise a cooling apparatus (not shown) thermally connected to the external fluid conduit 2210 to cool the dielectric heat transfer fluid. In other words, the thermal energy generated by the heat generating component 50 is primarily collected by the dielectric heat transfer fluid under normal operation conditions of the main cooling arrangement 1100_{D}.

In this embodiment, the external thermal transfer surface 1124_{B} of the backup liquid cooling block 1140_{B} is disposed in contact, either directly or by use of a thermal paste, with the heat generating component 50, such that the backup liquid cooling block 1140_{B} is thermally connected thereto. As such, in the event of a rise of the temperature of the heat generating component 50 and/or of the temperature of the dielectric heat transfer fluid in a vicinity of the thermal fuse that may be, for example, due to a failure of the pump 2220, the temperature of the thermal fuse 100 rises. In response to the temperature of the thermal fuse 100 being above the melting temperature, the state of the thermal fuse 100 changes from the solid state to the melted state, thereby enabling a flow of the backup heat transfer fluid in the cooling loop of the backup cooling arrangement 1100_{B}, the flow being maintained by the backup pump 1150_{B}. Therefore, thermal energy generated by the heat generating component 50 that may not be properly collected by the dielectric heat transfer fluid of the main cooling arrangement 1100_{D} is collected by the backup heat transfer fluid flowing in the internal conduit 110_{B} of the backup liquid cooling block 1140_{B}. It is contemplated that the pump 2220 may be mounted in the tank 2200 and submerged in the dielectric heat transfer fluid.

As described with respect to Figure 4, the backup cooling arrangement 1100_{B} of the cooling system 3000 comprises the controller 20 and the temperature sensor 1195 for sensing a temperature of the heat generating component 50, the temperature sensor 1195 being communicably connected to the controller 20. The backup pump 1150_{B} is communicably connected to the controller 20 such that the controller 20 may, in response to the temperature sensor 1195 sensing a temperature of the heat generating component 50 above the heat generating component temperature threshold (e.g. set according to the melting temperature of the thermal fuse 100), actuate the backup pump 1150_{B}.

In this embodiment, a plurality of fins 1145_{B} may be disposed on an upper surface of the backup liquid cooling block 1140_{B}, the upper surface being opposed to the external thermal transfer surface 1124_{B}, the plurality of fins 1145_{B} facilitating dissipation of thermal energy collected by the backup heat transfer fluid into the dielectric heat transfer fluid flowing in the tank 2200. Additionally or optionally, a layer of a porous material (not shown) may be disposed on the upper surface of the backup liquid cooling block 1140_{B}, the porous material being made of a material selected such that nucleate boiling of the porous material arises in response to the temperature of the backup heat transfer fluid being higher than a boiling temperature threshold. Thermal energy may thus be transferred from the backup heat transfer fluid to the dielectric heat transfer fluid *via* nucleate boiling of the porous material.

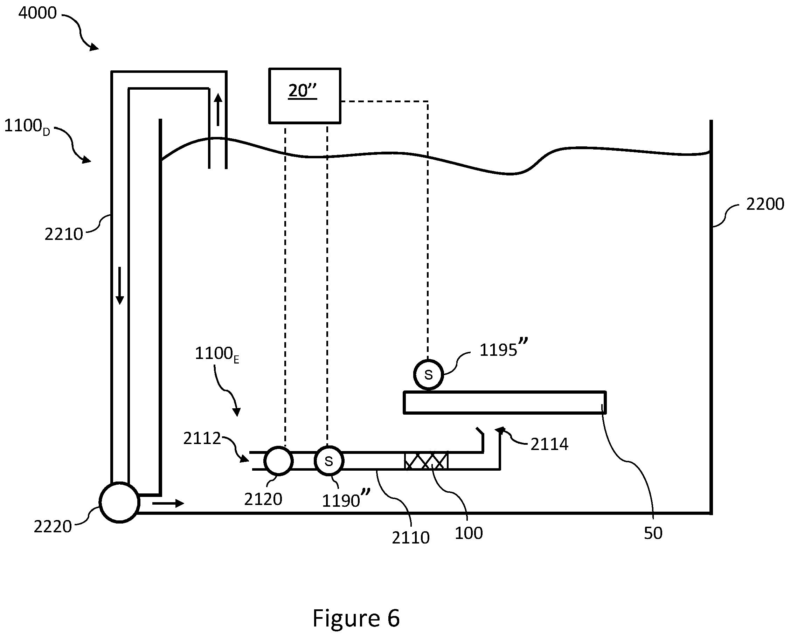

Figure 6 is a schematic diagram of a cooling system 4000 in which the cooling arrangement 1100_{D} is a main cooling arrangement, the cooling system 4000 also comprising a backup cooling arrangement 1100_{E}. In this embodiment, the heat generating component 50 is at least partially immersed within the tank 2200 with the dielectric heat transfer fluid. The backup cooling arrangement 1100_{E} comprises a fluid conduit 2110 defining a fluid inlet 2112 and a fluid outlet 2114, the fluid conduit 2110 being immersed within the tank 2200. The backup cooling arrangement 1100_{E} further comprises a backup pump 2120 immersed in the dielectric heat transfer fluid and configured for maintaining a flow of the dielectric heat transfer fluid within the fluid conduit 2110.

In this embodiment, the thermal fuse 100 is initially disposed in its solid state within the fluid conduit 2110 such that the flow of the dielectric heat transfer fluid within the fluid conduit 2110 is opposed by the thermal fuse 100. In response to the temperature of the thermal fuse 100 being higher than its melting temperature (e.g. due to overheating of the heat generating component 50 and/or a failure of the main cooling arrangement 1100_{D}), the thermal fuse 100 melts such that a flow of the dielectric heat transfer fluid is enabled in fluid conduit 2110 and maintained by the backup pump 2120. The thermal fuse may be disposed at any point within the fluid conduit 2110.

Upon the thermal fuse 100 being melted, the fluid conduit 2110, in collaboration with the backup pump 2120, causes the dielectric heat transfer fluid of the tank 2200 to be directed from the fluid outlet 2114 to the fluid inlet 2112, the fluid inlet 2112 being located in a vicinity of the heat generating component 50 such that a collection of thermal energy generated therefrom may be facilitated. Indeed, the fluid conduit 2110 and the backup pump 2120 may increase a fluid velocity of the dielectric heat transfer fluid around the heat generating component, thereby accelerating thermal energy carriage by the dielectric fluid in a vicinity of the heat generating component 50.

In this embodiment, the backup cooling arrangement 1100_{E} comprises a controller 20" that may be similar to the controller 20, and a temperature sensor 1995" for sensing a temperature of the heat generating component 50, the temperature sensor 1995" being communicably connected to the controller 20". The backup pump 2120 is communicably connected to the controller 20", the controller 20" actuating the backup pump 2120 in response to the temperature sensor 1195" sensing a temperature of the heat generating component 50 being above the heat generating component temperature threshold (e.g. set according to the melting temperature of the thermal fuse 100).

The backup cooling arrangement 1100_{E} also comprise a flow rate sensor 1190", similar to the flow rate sensor 1190, to sense a flow of the dielectric fluid within the fluid conduit 2110. In a non-limiting embodiment, the flow rate sensor 1190" may be communicably connected to the controller 20" to provide data thereto, the data comprising indication of a flow of the dielectric fluid within the open cooling loop.

The backup cooling arrangement 1100_{E} may also comprise a flow rate sensor (not shown), similar to the flow rate sensor 1190, to sense a flow of the dielectric fluid within the fluid conduit 2110. In a non-limiting embodiment, the flow rate sensor may be communicably connected to the controller 20" to provide data thereto, the data comprising indication of a flow of the dielectric fluid within the fluid conduit 2110.

It should be expressly understood that not all technical effects mentioned herein need to be enjoyed in each and every embodiment of the present technology.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A cooling system (1500, 2000, 3000, 4000) for cooling a heat generating component (50), the cooling system comprising:
a main cooling arrangement (1100A, 1100D) thermally coupled to the heat generating component (50), and configured for collecting thermal energy of the heat generating component (50) via a main heat transfer fluid; and
a backup cooling arrangement (1100B, 1100C, 1100E) thermally coupled to the main cooling arrangement (1100A, 1100D), the backup cooling arrangement (1100B, 1100C, 1100E) comprising:
at least one fluid path configured for conducting a backup heat transfer fluid;
the cooling system (1500, 2000, 3000, 4000) being **characterized in that** the backup cooling arrangement (1100B, 1100C, 1100E) further comprises:
a thermal fuse (100) disposed within at least a portion of the at least one fluid path, the thermal fuse (100) changing from a solid state to a melted state and selectively enabling a flow of the backup heat transfer fluid in the at least one fluid path of the backup cooling arrangement (1100B, 1100C, 1100E) in response to its temperature being above a temperature threshold, the backup heat transfer fluid being configured to, upon flowing in the at least one fluid path, collect thermal energy from the main cooling arrangement (1100A, 1100D).

2. The cooling system (1500, 2000, 3000, 4000) of claim 1, wherein the at least one fluid path of the backup cooling arrangement (1100B, 1100C, 1100E) comprises a backup cooling loop (1120B), the thermal fuse (100) being disposed within the backup cooling loop (1120B), the backup cooling loop (1120B) comprising:
a backup liquid cooling block (1140B) having a backup internal fluid conduit (1110B), the backup liquid cooling block (1140B) being thermally coupled to the main cooling arrangement (1100A, 1100D); and
a backup pump (1150B) fluidly connected to the backup internal fluid conduit (1110B), the backup pump (1150B) being adapted for causing the backup heat transfer fluid to flow within the backup cooling loop (1120B).

3. The cooling system (1500, 2000, 3000, 4000) of claim 2, wherein the thermal fuse (100) is disposed within the backup internal fluid conduit (1110B), the thermal fuse (100) being configured to inhibit the flow of the backup heat transfer fluid within the backup internal fluid conduit (1110B) in response to an initial temperature of the thermal fuse (100) being below the temperature threshold upon being disposed within the backup internal fluid conduit (1110B).

4. The cooling system (1500, 2000, 3000, 4000) of claim 2, wherein the thermal fuse (100) is disposed at an inlet (1142B) of the backup internal fluid conduit, the thermal fuse (100) being configured to inhibit the flow of the backup heat transfer fluid within the backup internal fluid conduit (1110B) in response to an initial temperature of the thermal fuse (100) being below the temperature threshold upon being disposed within the backup internal fluid conduit (1110B).

5. The cooling system (1500, 2000, 3000, 4000) of any one of claims 2 to 4, wherein the main cooling arrangement (1100A, 1100D) comprises a main cooling loop (1120A) comprising:
a main liquid cooling block (1140A) having a main internal fluid conduit (1110A), the main liquid cooling block (1140A) being thermally coupled to the heat generating component (50) such that, in use, thermal energy of the heat generating component (50) is collected by the main heat transfer fluid flowing in the main internal fluid conduit (1110A); and
a main pump (1150A) fluidly connected to the main internal fluid conduit (1110A), the main pump (1150A) being adapted for causing the main heat transfer fluid to flow within the main cooling loop (1120A).

6. The cooling system (1500, 2000, 3000, 4000) of claim 1, wherein the backup heat transfer fluid is a dielectric heat transfer fluid, the backup cooling arrangement (1100B, 1100C, 1100E) further comprising:
a tank (2200) filled with the dielectric heat transfer fluid for immersive cooling of the heat generating component (50), the heat generating component (50) being disposed within the tank (2200) such that thermal energy generated therefrom is collected by the dielectric heat transfer fluid; and
an immersive cooling pump (2220) adapted for causing the dielectric heat transfer fluid to flow within the tank (2200), the dielectric heat transfer fluid flowing in the at least one fluid path is being extracted from the tank (2200) by the immersive cooling pump (2220).

7. The cooling system (1500, 2000, 3000, 4000) of claim 6, wherein the backup cooling arrangement (1100B, 1100C, 1100E) is an open cooling loop fluidly connected to the tank (2200).

8. The cooling system (1500, 2000, 3000, 4000) of claim 1, wherein the main heat transfer fluid is a dielectric heat transfer fluid, the main cooling arrangement (1100A, 1100D) comprises:
a tank (2200) filled with the dielectric heat transfer fluid for immersive cooling of the heat generating component, the heat generating component (50) being disposed within the tank such that thermal energy generated therefrom is collected by the dielectric heat transfer fluid; and
an immersive cooling pump (2220) adapted for causing the dielectric heat transfer fluid to flow within the tank (2200).

9. The cooling system (1500, 2000, 3000, 4000) of claim 1, wherein:
the main and backup heat transfer fluids are a same dielectric heat transfer fluid, and
the main cooling arrangement (1100A, 1100D) comprises:
a tank (2200) filled with the dielectric heat transfer fluid for immersive cooling of the heat generating component (50), the heat generating component (50) being disposed within the tank (2200) such that thermal energy generated therefrom is collected by the dielectric heat transfer fluid; and
an immersive cooling pump (2220) adapted for causing the dielectric heat transfer fluid to flow within the tank (2200);
the at least one fluid path of the backup cooling arrangement (1100B, 1100C, 1100E) being immersed within the tank (2200) and being fluidly connected therewith, the backup cooling arrangement (1100B, 1100C, 1100E) further comprising a backup pump adapted for causing the dielectric heat transfer fluid to flow within the at least one fluid path.

10. The cooling system (1500, 2000, 3000, 4000) of any one of claims 1 to 9, wherein the thermal fuse (100) comprises a phase change material.

11. The cooling system (1500, 2000, 3000, 4000) of claim 10, wherein the phase change material comprises paraffin wax.

12. The cooling system (1500, 2000, 3000, 4000) of any one of claims 1 to 11, wherein the backup cooling arrangement (1100B, 1100C, 1100E) further comprises a flow rate sensor (1190, 1190') adapted for sensing a flow of the backup heat transfer fluid in the at least one fluid path, the flow rate sensor (1190, 1190') being communicably connected to a controller.

13. The cooling system (1500, 2000, 3000, 4000) of claim 12, wherein the flow rate sensor (1190, 1190') is adapted for providing to the controller a signal indicative of a flow of the backup heat transfer fluid in the at least one fluid path.

14. The cooling system (1500, 2000, 3000, 4000) of any one of claims 1 to 11, wherein the backup cooling arrangement (1100B, 1100C, 1100E) further comprises a temperature sensor (1195, 1195") configured for sensing a temperature of the heat generating component (50), the temperature sensor (1195, 1195") being communicably connected to a controller to provide the controller with a signal in response to the temperature of the heat generating component (50) being higher than the temperature threshold.

15. The cooling system (1500, 2000, 3000, 4000) of any one of claims 1 to 14, wherein the thermal fuse (100) is dissolved in the backup heat transfer fluid in response to its temperature being higher than the temperature threshold.

## Patentansprüche

1. Kühlungssystem (1500, 2000, 3000, 4000) zum Kühlen einer Wärmeerzeugungskomponente (50), wobei das Kühlungssystem Folgendes umfasst:
eine Hauptkühlungsanordnung (1100A, 1100D), die thermisch mit der Wärmeerzeugungskomponente (50) gekoppelt ist und so konfiguriert ist, dass sie thermische Energie der Wärmeerzeugungskomponente (50) über ein Hauptwärmeübertragungsfluid sammelt; und
eine Backup-Kühlungsanordnung (1100B, 1100C, 1100E), die thermisch mit der Hauptkühlungsanordnung (1100A, 1100D) gekoppelt ist, wobei die Backup-Kühlungsanordnung (1100B, 1100C, 1100E) Folgendes umfasst:
mindestens einen Fluidverlauf, der zum Leiten eines Backup-Wärmeübertragungsfluids konfiguriert ist;
wobei das Kühlungssystem (1500, 2000, 3000, 4000) **dadurch gekennzeichnet ist, dass** die Backup-Kühlungsanordnung (1100B, 1100C, 1100E) ferner Folgendes umfasst:
eine Thermosicherung (100), die innerhalb mindestens eines Abschnitts des mindestens einen Fluidverlaufs angeordnet ist, wobei die Thermosicherung (100) von einem festen Zustand in einen geschmolzenen Zustand wechselt und selektiv einen Fluss des Backup-Wärmeübertragungsfluids in dem mindestens einen Fluidverlauf der Backup-Kühlungsanordnung (1100B, 1100C, 1100E) als Reaktion darauf ermöglicht, dass seine Temperatur oberhalb eines Temperaturschwellenwerts ist, wobei das Backup-Wärmeübertragungsfluid so konfiguriert ist, dass es beim Fließen in dem mindestens einen Fluidverlauf thermische Energie von der Hauptkühlungsanordnung (1100A, 1100D) sammelt.

2. Kühlungssystem (1500, 2000, 3000, 4000) nach Anspruch 1, wobei der mindestens eine Fluidverlauf der Backup-Kühlungsanordnung (1100B, 1100C, 1100E) eine Backup-Kühlungsschleife (1120B) umfasst, wobei die Thermosicherung (100) innerhalb der Backup-Kühlungsschleife (1120B) angeordnet ist, wobei die Backup-Kühlungsschleife (1120B) Folgendes umfasst:
einen Backup-Flüssigkeitskühlungsblock (1140B), der eine interne Backup-Fluidleitung (1110B) hat, wobei der Backup-Flüssigkeitskühlungsblock (1140B) thermisch mit der Hauptkühlungsanordnung (1100A, 1100D) gekoppelt ist; und
eine Backup-Pumpe (1150B), die fluidisch mit der internen Backup-Fluidleitung (1110B) verbunden ist, wobei die Backup-Pumpe (1150B) so angepasst ist, dass sie das Backup-Wärmeübertragungsfluid dazu veranlasst, innerhalb der Backup-Kühlungsschleife (1120B) zu fließen.

3. Kühlungssystem (1500, 2000, 3000, 4000) nach Anspruch 2, wobei die Thermosicherung (100) innerhalb der internen Backup-Fluidleitung (1110B) angeordnet ist, wobei die Thermosicherung (100) so konfiguriert ist, dass sie als Reaktion darauf, dass eine Anfangstemperatur der Thermosicherung (100) unterhalb des Temperaturschwellenwerts ist, wenn sie innerhalb der internen Backup-Fluidleitung (1110B) angeordnet ist, den Fluss des Backup-Wärmeübertragungsfluids innerhalb der internen Backup-Fluidleitung (1110B) hemmt.

4. Kühlungssystem (1500, 2000, 3000, 4000) nach Anspruch 2, wobei die Thermosicherung (100) an einem Einlass (1142B) der internen Backup-Fluidleitung angeordnet ist, wobei die Thermosicherung (100) so konfiguriert ist, dass sie als Reaktion darauf, dass eine Anfangstemperatur der Thermosicherung (100) unterhalb des Temperaturschwellenwerts ist, wenn sie innerhalb der internen Backup-Fluidleitung (1110B) angeordnet ist, den Fluss des Backup-Wärmeübertragungsfluids innerhalb der internen Backup-Fluidleitung (1110B) hemmt.

5. Kühlungssystem (1500, 2000, 3000, 4000) nach einem der Ansprüche 2 bis 4, wobei die Hauptkühlungsanordnung (1100A, 1100D) eine Hauptkühlungsschleife (1120A) umfasst, die Folgendes umfasst:
einen Hauptflüssigkeitskühlungsblock (1140A) mit einer internen Hauptfluidleitung (1110A), wobei der Hauptflüssigkeitskühlungsblock (1140A) thermisch mit der Wärmeerzeugungskomponente (50) derart gekoppelt ist, dass bei der Verwendung thermische Energie der Wärmeerzeugungskomponente (50) von dem Hauptwärmeübertragungsfluid, das in der internen Hauptfluidleitung (1110A) fließt, gesammelt wird; und
eine Hauptpumpe (1150A), die mit der internen Hauptfluidleitung (1110A) fluidisch verbunden ist, wobei die Hauptpumpe (1150A) so angepasst ist, dass sie das Hauptwärmeübertragungsfluid dazu veranlasst, innerhalb der Hauptkühlungsschleife (1120A) zu fließen.

6. Kühlungssystem (1500, 2000, 3000, 4000) nach Anspruch 1, wobei das Backup-Wärmeübertragungsfluid ein dielektrisches Wärmeübertragungsfluid ist, wobei die Backup-Kühlungsanordnung (1100B, 1100C, 1100E) ferner Folgendes umfasst:
einen Tank (2200), der zum immersiven Kühlen der Wärmeerzeugungskomponente (50) mit dem dielektrischen Wärmeübertragungsfluid gefüllt ist, wobei die Wärmeerzeugungskomponente (50) derart innerhalb des Tanks (2200) angeordnet ist, dass daraus erzeugte thermische Energie von dem dielektrischen Wärmeübertragungsfluid gesammelt wird; und
eine Immersionskühlungspumpe (2220), die so angepasst ist, dass sie das dielektrische Wärmeübertragungsfluid dazu veranlasst, innerhalb des Tanks (2200) zu fließen, wobei das dielektrische Wärmeübertragungsfluid, das in dem mindestens einen Fluidverlauf fließt, von der Immersionskühlungspumpe (2220) aus dem Tank (2200) extrahiert wird.

7. Kühlungssystem (1500, 2000, 3000, 4000) nach Anspruch 6, wobei die Backup-Kühlungsanordnung (1100B, 1100C, 1100E) eine offene Kühlungsschleife ist, die fluidisch mit dem Tank (2200) verbunden ist.

8. Kühlungssystem (1500, 2000, 3000, 4000) nach Anspruch 1, wobei das Hauptwärmeübertragungsfluid ein dielektrisches Wärmeübertragungsfluid ist, wobei die Hauptkühlungsanordnung (1100A, 1100D) Folgendes umfasst:
einen Tank (2200), der zum immersiven Kühlen der Wärmeerzeugungskomponente mit dem dielektrischen Wärmeübertragungsfluid gefüllt ist, wobei die Wärmeerzeugungskomponente (50) derart innerhalb des Tanks angeordnet ist, dass daraus erzeugte thermische Energie von dem dielektrischen Wärmeübertragungsfluid gesammelt wird; und
eine Immersionskühlungspumpe (2220), die so angepasst ist, dass sie das dielektrische Wärmeübertragungsfluid dazu veranlasst, innerhalb des Tanks (2200) zu fließen.

9. Kühlungssystem (1500, 2000, 3000, 4000) nach Anspruch 1, wobei:
das Haupt- und das Backup-Wärmeübertragungsfluid dasselbe dielektrische Wärmeübertragungsfluid sind und
die Hauptkühlungsanordnung (1100A, 1100D) Folgendes umfasst:
einen Tank (2200), der zum immersiven Kühlen der Wärmeerzeugungskomponente (50) mit dem dielektrischen Wärmeübertragungsfluid gefüllt ist, wobei die Wärmeerzeugungskomponente (50) derart innerhalb des Tanks (2200) angeordnet ist, dass daraus erzeugte thermische Energie von dem dielektrischen Wärmeübertragungsfluid gesammelt wird; und
eine Immersionskühlungspumpe (2220), die so angepasst ist, dass sie das dielektrische Wärmeübertragungsfluid dazu veranlasst, innerhalb des Tanks (2200) zu fließen;
wobei der mindestens eine Fluidverlauf der Backup-Kühlungsanordnung (1100B, 1100C, 1100E) innerhalb des Tanks (2200) eingetaucht und mit diesem fluidisch verbunden ist, wobei die Backup-Kühlungsanordnung (1100B, 1100C, 1100E) ferner eine Backup-Pumpe umfasst, die so angepasst ist, dass sie das dielektrische Wärmeübertragungsfluid dazu veranlasst, innerhalb des mindestens einen Fluidverlaufs zu fließen.

10. Kühlungssystem (1500, 2000, 3000, 4000) nach einem der Ansprüche 1 bis 9, wobei die Thermosicherung (100) ein Phasenwechselmaterial umfasst.

11. Kühlungssystem (1500, 2000, 3000, 4000) nach Anspruch 10, wobei das Phasenwechselmaterial Paraffinwachs umfasst.

12. Kühlungssystem (1500, 2000, 3000, 4000) nach einem der Ansprüche 1 bis 11, wobei die Backup-Kühlungsanordnung (1100B, 1100C, 1100E) ferner einen Durchflussratensensor (1190, 1190') umfasst, der so angepasst ist, dass er einen Fluss des Backup-Wärmeübertragungsfluids in dem mindestens einen Fluidverlauf erfasst, wobei der Durchflussratensensor (1190, 1190') kommunizierbar mit einer Steuerung verbunden ist.

13. Kühlungssystem (1500, 2000, 3000, 4000) nach Anspruch 12, wobei der Durchflussratensensor (1190, 1190') so angepasst ist, dass er der Steuerung ein Signal bereitstellt, das einen Fluss des Backup-Wärmeübertragungsfluids in dem mindestens einen Fluidverlauf anzeigt.

14. Kühlungssystem (1500, 2000, 3000, 4000) nach einem der Ansprüche 1 bis 11, wobei die Backup-Kühlungsanordnung (1100B, 1100C, 1100E) ferner einen Temperatursensor (1195, 1195'') umfasst, der so konfiguriert ist, dass er eine Temperatur der Wärmeerzeugungskomponente (50) erfasst, wobei der Temperatursensor (1195, 1195") kommunizierbar mit einer Steuerung verbunden ist, um der Steuerung als Reaktion darauf ein Signal bereitzustellen, dass die Temperatur der Wärmeerzeugungskomponente (50) höher als der Temperaturschwellenwert ist.

15. Kühlungssystem (1500, 2000, 3000, 4000) nach einem der Ansprüche 1 bis 14, wobei die Thermosicherung (100) in dem Backup-Wärmeübertragungsfluid als Reaktion darauf gelöst wird, dass seine Temperatur höher als der Temperaturschwellenwert ist.

## Revendications

1. Système de refroidissement (1500, 2000, 3000, 4000) pour refroidir un composant générateur de chaleur (50), le système de refroidissement comprenant :
un agencement de refroidissement principal (1100A, 1100D) couplé thermiquement au composant générateur de chaleur (50) et configuré pour collecter l'énergie thermique du composant générateur de chaleur (50) via un fluide de transfert de chaleur principal ; et
un agencement de refroidissement de secours (1100B, 1100C, 1100E) couplé thermiquement à **l'agencement** de refroidissement principal (1100A, 1100D), l'agencement de refroidissement de secours (1100B, 1100C, 1100E) comprenant :
au moins un trajet de fluide configuré pour acheminer un fluide de transfert de chaleur de secours ;
le système de refroidissement (1500, 2000, 3000, 4000) étant **caractérisé en ce que** l'agencement de refroidissement de secours (1100B, 1100C, 1100E) comprend également :
un fusible thermique (100) disposé à l'intérieur d'au moins une partie de l'au moins un trajet de fluide, le fusible thermique (100) passant d'un état solide à un état fondu et permettant sélectivement un écoulement du fluide de transfert de chaleur de secours dans l'au moins un trajet de fluide de l'agencement de refroidissement de secours (1100B, 1100C, 1100E) en réponse à sa température supérieure à un seuil de température, le fluide de transfert de chaleur de secours étant configuré pour, lors de l'écoulement dans l'au moins un trajet de fluide, collecter l'énergie thermique de l'agencement de refroidissement principal (1100A, 1100D).

2. Système de refroidissement (1500, 2000, 3000, 4000) selon la revendication 1, dans lequel l'au moins un circuit de fluide de l'agencement de refroidissement de secours (1100B, 1100C, 1100E) comprend une boucle de refroidissement de secours (1120B), le fusible thermique (100) étant disposé à l'intérieur de la boucle de refroidissement de secours (1120B), la boucle de refroidissement de secours comprenant :
un bloc de refroidissement liquide de secours (1140B) présentant d'un conduit de fluide interne de secours (1110B), le bloc de refroidissement liquide de secours (1140B) étant couplé thermiquement à l'agencement de refroidissement principal (1100A, 1100D) ; et
une pompe de secours (1150B) reliée fluidiquement au conduit de fluide interne de secours (1110B), la pompe de secours (1150B) étant adaptée pour provoquer l'écoulement du fluide de transfert de chaleur de secours dans la boucle de refroidissement de secours (1120B).

3. Système de refroidissement (1500, 2000, 3000, 4000) selon la revendication 2, dans lequel le fusible thermique (100) est disposé à l'intérieur du conduit de fluide interne de secours (1110B), le fusible thermique (100) étant configuré pour inhiber l'écoulement du fluide de transfert de chaleur de secours à l'intérieur du conduit de fluide interne de secours (1110B) en réponse à une température initiale du fusible thermique (100) inférieure au seuil de température lorsqu'il est disposé à l'intérieur du conduit de fluide interne de secours (1110B).

4. Système de refroidissement (1500, 2000, 3000, 4000) selon la revendication 2, dans lequel le fusible thermique (100) est disposé au niveau d'une entrée (1142B) du conduit de fluide interne de secours, le fusible thermique (100) étant configuré pour inhiber l'écoulement du fluide de transfert de chaleur de secours à l'intérieur du conduit de fluide interne de secours (1110B) en réponse à une température initiale du fusible thermique (100) inférieure au seuil de température lorsqu'il est disposé à l'intérieur du conduit de fluide interne de secours (1110B).

5. Système de refroidissement (1500, 2000, 3000, 4000) selon l'une quelconque des revendications 2 à 4, dans lequel l'agencement de refroidissement principal (1100A, 1100D) comprend une boucle de refroidissement principale (1120A) comprenant :
un bloc de refroidissement liquide principal (1140A) présentant un conduit de fluide interne principal (1110A), le bloc de refroidissement liquide principal (1140A) étant couplé thermiquement au composant de génération de chaleur (50) de telle sorte que, lors de l'utilisation, l'énergie thermique du composant de génération de chaleur (50) est collectée par le fluide de transfert de chaleur principal circulant dans le conduit de fluide interne principal (1110A) ; et
une pompe principale (1150A) reliée fluidiquement au conduit de fluide interne principal (1110A), la pompe principale (1150A) étant adaptée pour amener le fluide de transfert de chaleur principal à s'écouler dans la boucle de refroidissement principale (1120A).

6. Système de refroidissement (1500, 2000, 3000, 4000) selon la revendication 1, dans lequel le fluide de transfert de chaleur de secours est un fluide de transfert de chaleur diélectrique, l'agencement de refroidissement de secours (1100B, 1100C, 1100E) comprenant également :
un réservoir (2200) rempli avec le fluide de transfert de chaleur diélectrique pour le refroidissement immergé du composant générateur de chaleur (50), le composant générateur de chaleur (50) étant disposé à l'intérieur du réservoir (2200) de telle sorte que l'énergie thermique générée à partir de celui-ci soit collectée par le fluide de transfert de chaleur diélectrique ; et
une pompe de refroidissement immersive (2220) adaptée pour amener le fluide de transfert de chaleur diélectrique à s'écouler à l'intérieur du réservoir (2200), le fluide de transfert de chaleur diélectrique s'écoulant dans l'au moins un trajet de fluide étant extrait du réservoir (2200) par la pompe de refroidissement immersive (2220).

7. Système de refroidissement (1500, 2000, 3000, 4000) selon la revendication 6, dans lequel l'agencement de refroidissement de secours (1100B, 1100C, 1100E) est une boucle de refroidissement ouverte reliée fluidiquement au réservoir (2200).

8. Système de refroidissement (1500, 2000, 3000, 4000) selon la revendication 1, dans lequel le fluide de transfert de chaleur principal est un fluide de transfert de chaleur diélectrique, l'agencement de refroidissement principal (1100A, 1100D) comprenant :
un réservoir (2200) rempli avec le fluide de transfert de chaleur diélectrique pour le refroidissement immergé du composant générateur de chaleur, le composant générateur de chaleur (50) étant disposé à l'intérieur du réservoir de telle sorte que l'énergie thermique générée à partir de celui-ci soit collectée par le fluide de transfert de chaleur diélectrique ; et
une pompe de refroidissement immersive (2220) adaptée pour provoquer l'écoulement du fluide de transfert de chaleur diélectrique à l'intérieur du réservoir (2200).

9. Système de refroidissement (1500, 2000, 3000, 4000) selon la revendication 1, dans lequel :
les fluides de transfert de chaleurs principal et de secours sont un même fluide de transfert de chaleur diélectrique, et l'agencement de refroidissement principal (1100A, 1100D) comprend :
un réservoir (2200) rempli avec le fluide de transfert de chaleur diélectrique pour le refroidissement immergé du composant générateur de chaleur (50), le composant générateur de chaleur (50) étant disposé à l'intérieur du réservoir (2200) de telle sorte que l'énergie thermique générée à partir de celui-ci soit collectée par le fluide de transfert de chaleur diélectrique ; et
une pompe de refroidissement immersive (2220) adaptée pour provoquer l'écoulement du fluide de transfert de chaleur diélectrique à l'intérieur du réservoir (2200) ;
l'au moins un trajet de fluide du dispositif de refroidissement de secours (1100B, 1100C, 1100E) étant immergés dans le réservoir (2200) et étant reliés fluidiquement à celui-ci, l'agencement de refroidissement de secours (1100B, 1100C, 1100E) comprenant également une pompe de secours adaptée pour amener le fluide de transfert de chaleur diélectrique à s'écouler dans l'au moins un trajet de fluide.

10. Système de refroidissement (1500, 2000, 3000, 4000) selon l'une quelconque des revendications 1 à 9, dans lequel le fusible thermique (100) comprend un matériau à changement de phase.

11. Système de refroidissement (1500, 2000, 3000, 4000) selon la revendication 10, dans lequel le matériau à changement de phase comprend de la cire de paraffine.

12. Système de refroidissement (1500, 2000, 3000, 4000) selon l'une quelconque des revendications 1 à 11, dans lequel l'agencement de refroidissement de secours (1100B, 1100C, 1100E) comprend également un capteur de débit (1190, 1190') adapté pour détecter un débit du fluide de transfert de chaleur de secours dans l'au moins un trajet de fluide, le capteur de débit (1190, 1190') étant connecté de manière communicative à un dispositif de commande.

13. Système de refroidissement (1500, 2000, 3000, 4000) selon la revendication 12, dans lequel le capteur de débit (1190, 1190') est adapté pour fournir au dispositif de commande un signal indicatif d'un écoulement du fluide de transfert de chaleur de secours dans l'au moins un trajet de fluide.

14. Système de refroidissement (1500, 2000, 3000, 4000) selon l'une quelconque des revendications 1 à 11, dans lequel l'agencement de refroidissement de secours (1100B, 1100C, 1100E) comprend également un capteur de température (1195, 1195") configuré pour détecter une température du composant générateur de chaleur (50), le capteur de température (1195, 1195") étant connecté de manière communicative à un dispositif de commande pour fournir au dispositif de commande un signal en réponse à la température du composant générateur de chaleur (50) qui est supérieure au seuil de température.

15. Système de refroidissement (1500, 2000, 3000, 4000) selon l'une quelconque des revendications 1 à 14, dans lequel le fusible thermique (100) est dissous dans le fluide de transfert de chaleur de secours en réponse au fait que sa température est supérieure au seuil de température.
